Europäisches Patentamt

**European Patent Office**

Office européen des brevets

(11) Numéro de publication: **0 235 477 B1**

(12) FASCICULE DE BREVET EUROPEEN

(19)

(45) Date de publication de fascicule du brevet: **20.05.92** (51) Int. Cl.⁵: **H03M 13/00, H04K 3/00**

(21) Numéro de dépôt: **86402859.2**

(22) Date de dépôt: **19.12.86**

(54) **Procédé et dispositif de transmission radioélectrique d'informations codées, résistant au brouillage.**

(30) Priorité: **23.12.85 FR 8519068**

(43) Date de publication de la demande:
**09.09.87 Bulletin 87/37**

(45) Mention de la délivrance du brevet:
**20.05.92 Bulletin 92/21**

(84) Etats contractants désignés:
**DE GB IT**

(56) Documents cités:
**US-A- 4 100 374**
**US-A- 4 394 642**

**CLARK et CAIN: "Error correcting coding for digital communication", 1981, pages 349-352, Plenum Press, US**

**D. Knuth, "The art of computer Programming", vol. 2, Reading, MA: Addison-Wesley, 1969, pp 15-19**

**IEEE Transactions on Communications COM-26, pp 406-408, 03, 1978**

**G.C. Clark, J.B. Cain: "Error Correction Co-**
ding for Digital Communications", 1981, pp 345-347

(73) Titulaire: **THOMSON-CSF**
**51, Esplanade du Général de Gaulle**
**F-92800 Puteaux(FR)**

(72) Inventeur: **Barido, Richard**
**THOMSON-CSF SCPI 19, avenue de Messine**
**F-75008 Paris(FR)**

(74) Mandataire: **Turlèque, Clotilde et al**
**THOMSON-CSF SCPI**
**F-92045 PARIS LA DEFENSE CEDEX 67(FR)**

Rank Xerox (UK) Business Services
(3.08/2.19/2.0)

## Description

L'Invention se rapporte au domaine de la transmission radioélectrique d'informations, en particulier pour la transmission d'informations numériques codées, et plus particulièrement à un procédé et à un dispositif de transmission radioélectrique d'informations codées, résistant au brouillage.

De manière classique, les informations numériques à transmettre par voie radioélectrique sont codées de façon à introduire en plus de l'information utile une redondance qui permet, lors de la réception, de corriger des erreurs isolées ou en paquets dans les données reçues. Ainsi, les codes BCH permettent de transformer un mot d'information de longueur p en un mot codé de longueur n, n supérieur à p, permettant de corriger t erreurs lors de la réception du mot codé de longueur n.

A la réception, des erreurs isolées ou par paquets sont créées. Une méthode permettant de réaliser une correction d'au moins certaines de ces erreurs consiste à répartir lors de la transmission les erreurs groupées sur plusieurs mots de code, de façon à augmenter la probabilité de correction en réception.

Pour cela, de manière également classique comme décrit par exemple dans le brevet US-A-4 100 374, la transmission est faite après entrelacement, les mots codés de longueur n étant rangés dans les lignes d'une matrice dite matrice d'entrelacement lue en colonnes pour l'émission. Ainsi, un paquet de B.t erreurs maximum sur l'ensemble des symboles entrelacés se traduit, après désentrelacement, par t erreurs maximum sur chaque mot de code : le paquet d'erreurs est donc entièrement corrigé.

Le retard de transmission introduit par cette méthode est le temps nécessaire au remplissage de la matrice tant à l'émission qu'à la réception. Le retard est donc 2Bn symboles. Classiquement, cet entrelacement est périodique : les symboles d'un même mot de code sont toujours distants de B symboles, B étant le nombre de lignes de la matrice. Dans de tels systèmes de transmission d'informations, des procédés de brouillage peuvent être mis en oeuvre par des tiers ennemis, pour brouiller la communication. Si le brouilleur a pu détecter les dimensions du bloc d'entrelacement, avec un signal brouilleur impulsif périodique, dans lequel les impulsions de brouillage sont espacées régulièrement dans le temps de B symboles, tous les symboles d'un même mot sont brouillés et son décodage est à coup sûr impossible.

Il existe un moyen pour lutter contre ce type de brouilleur, qui consiste à lire la matrice en suivant une loi pseudo-aléatoire connue de l'émetteur et du récepteur. La manière de générer une séquence pseudo-aléatoire est par exemple décrite dans "The art of computing programming", vol. 2, Reading MA ; Addison WESLEY 1969, pages 15-19. L'utilisation d'une telle loi est par exemple la solution décrite dans le livre intitulé "Error correction coding for digital communication" de George C. CLARK, Jr. et J. Bibb CAIN, aux pages 349-352. Dans ce système, une ou plusieurs permutations pseudo-aléatoires des nombres compris entre 1 et Bn correspondant aux positions des symboles dans la matrice sont générées, de la même manière en émission et en réception. L'inconvénient de ce procédé est que le choix d'une permutation quelconque des Bn symboles peut conduire à émettre les symboles d'un même mot codé de façon trop rapprochée. Ainsi par exemple pour des mots codés de longueur n = 12 et une matrice d'entrelacement comportant B = 13 lignes, avec un entrelacement classique périodique les symboles d'un même mot sont toujours distants de treize symboles ; une impulsion de brouillage couvrant douze symboles par exemple ne brouille donc au maximum qu'un symbole par mot. Par contre, avec un entrelacement pseudo-aléatoire du type décrit ci-dessus, il est tout à fait possible qu'une impulsion de brouillage couvrant 12 symboles brouille plusieurs symboles d'un même mot, et c'est précisément pour éviter cela que les mots codés étaient émis après entrelacement.

L'invention a pour objet un procédé, et le dispositif correspondant, de transmission d'informations codées résistant au brouillage par un brouilleur périodique sans rendre possible le brouillage par une impulsion longue, de plusieurs symboles d'un même mot.

Selon l'invention, le procédé de transmission d'informations codées par un code correcteur d'erreurs, résistant au brouillage, dans lequel les B.n symboles d'une séquence de B mots codés de n symboles, B et n nombres entiers, sont entrelacés après codage pour leur transmission, et réordonnés dans l'ordre initial résultant du codage pour le décodage après réception, est caractérisé en ce que :

- à l'émission, l'entrelacement est obtenu en émettant successivement les symboles de la séquence codée de rangs donnés par la suite $x_k = x_o + kp$ (modulo Bn), où $x_o$ est un rang de départ quelconque dans la séquence codée et p le pas de la suite, p étant un nombre entier premier, avec B.n, et k prenant les valeurs 0, 1 ... Bn-1,
- à la réception, l'ordre initial résultant du codage est retrouvé en rangeant les symboles successifs de la séquence entrelacée correspondante reçue aux rangs calculés par la même suite $x_k = x_o + kp$ (modulo B.n),

et en ce que le pas p de la suite est supérieur à n et choisi tel que l'intervalle minimum entre deux symboles d'un même mot dans la séquence entrelacée est supérieur ou égal à une valeur prédéfinie, ce pas étant déterminé à partir des paramètres de la séquence, nombre de mots B et nombre de symboles par mot, et les intervalles entre symboles d'un même mot prenant un nombre limité de valeurs.

L'invention sera mieux comprise et d'autres caractéristiques apparaîtront à l'aide de la description qui suit en référence aux figures annexées.

- La figure 1 est un exemple de séquence codée issue du dispositif de modulation ;
- La figure 2 représente la matrice utilisée pour mettre en mémoire la séquence codée ;
- La figure 3 représente une séquence générée selon l'art connu par entrelacement périodique ;
- La figure 4 représente une séquence générée selon l'art connu par entrelacement pseudo-aléatoire ;
- La figure 5 représente une séquence générée selon l'invention ;
- La figure 6 est un schéma synoptique des moyens de commande utilisés .

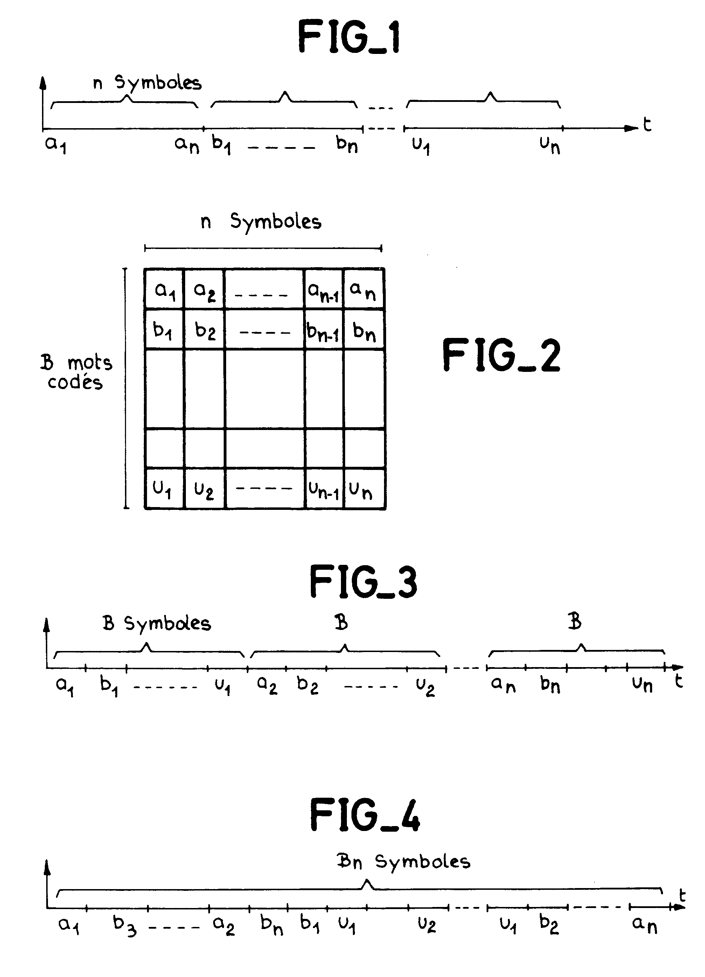

La figure 1 représente la suite des symboles issus du dispositif de codage modulation, comportant les bits de redondance, telle qu'elle est transmise à l'entrée d'un dispositif d'émission.

Les symboles $a_1$ ... $a_n$ sont les symboles d'un premier mot codé de n symboles, $b_1$ ... $b_n$ sont les symboles d'un deuxième mot codé, et $u_1$ , ... $u_n$ sont les symboles du $B^{ième}$ mot codé.

La figure 2 représente la matrice d'entrelacement dans laquelle les mots codés ont été rangés dans les B lignes de chacune n symboles.

La figure 3 représente la suite des symboles émis après entrelacement selon la méthode classique d'entrelacement périodique où les symboles sont lus colonne par colonne. Le premier mot émis est le mot de B symboles $a_1$ , $b_1$ ...$u_1$ , le second est $a_2$ , $b_2$ ... $u_2$ ... et la matrice est remplie ligne par ligne par une nouvelle suite de symboles après la transmission du dernier mot $a_n$ , $b_n$ , ... $u_n$.

La figure 4 représente la suite des symboles émis après un entrelacement pseudo-aléatoire quelconque comme décrit ci-dessus. Comme il a été indiqué, une impulsion de brouillage de durée B symboles peut brouiller plusieurs symboles d'un même mot et empêcher son décodage.

Selon l'invention, la transmission est effectuée après entrelacement des Bn symboles mis en mémoire, mais l'entrelacement n'est ni pseudo-aléatoire, ni périodique de période B.

L'entrelacement est réalisé en choisissant dans la matrice un rang de départ et en générant à partir de ce rang de départ une séquence de lecture particulière qui garantit une séparation minimale entre deux symboles d'un même mot de code. La séquence de lecture est définie de la manière suivante :

La lecture est réalisée à partir de deux paramètres :
- l'adresse comprise entre 1 et Bn du rang de départ dans la matrice ;
- p, un nombre premier avec de Bn.

La séquence de lecture de la matrice est alors :

$\{x_k\} = x_o + k.p$ modulo Bn, k = 0, 1, 2, 3, ... , Bn-1.

Cette séquence de lecture permet de lire tous les symboles mis en mémoire dans la matrice, et chaque symbole n'est lu qu'une fois. En effet : $x_k = x_o + k.p$ (modulo $B_n$), k = 0, 1, 2 ... Bn-1 est une séquence d'adressage comportant Bn nombres tous inférieurs à Bn. De plus, ces nombres sont tous différents car :

$$\text{si } x_{k_1} \text{ était égal à } x_{k_2} \text{ , } k_1, k_2 \in (0, 1, 2 ...Bn-1)$$

on aurait

$x_o + k_1 p = x_o + k_2 p$ (mod. Bn)
$(k_2 - k_1) p = 0$ (mod. Bn)

Or, par hypothèse p est premier avec Bn, donc Bn divise $(k_2 - k_1)$ et $(k_2 - k_1)$ est inférieur à Bn. Donc $k_2 - k_1 = 0$.

La séquence $\{x_k\} = x_o + kp$ (modulo Bn) contient bien tous les nombres de 1 à Bn, et chacun une seule fois.

Pour éviter que deux symboles d'un même mot ne soit émis successivement, c'est-à-dire ne se suivent dans la séquence $\{x_k\}$, le nombre p est choisi supérieur à n, nombre de symboles dans un mot.

L'intervalle minimal entre deux symboles d'un même mot est fonction du nombre p. En effet, soit $k_{min}$ cet intervalle minimal, $k_{min}$ est le plus petit entier k tel que : kp = M.B.n + z où $|z| < n$.

En effet, soient $x_i$ et $x_j$ les adresses de deux symboles d'un même mot codé, distants de k symboles dans la séquence émise, les k-1 symboles les séparant dans la séquence émise étant issus d'autres mots codés rangés dans la matrice.

3

Du fait de la méthode de génération de la séquence, $x_j$ - $x_i$ est le multiple d'ordre k de p modulo Bn :

$$|x_j - x_i| = kp \text{ (modulo Bn)}.$$

kp peut être écrit : kp = M(Bn) + r, le reste r entier naturel étant compris entre 0 et Bn, ou encore kp = M$'$(Bn) + z, le reste z entier relatif étant alors tel que z est compris entre 0 et $\frac{Bn}{2}$ , M$'$(Bn) pouvant être supérieur à kp.

Si r $\leq \frac{Bn}{2}$ alors z = r et M$'$ = M, et si r $\geq \frac{Bn}{2}$ alors z = r - Bn et M$'$ = M + 1.

L'analyse montre que $|z| < n$.

En effet, à partir de la lecture à une adresse quelconque $x_i$ dans la matrice, si on revient au bout des k lectures suivantes à une adresse $x_j$ dans la matrice, et si $x_i$ et $x_j$ sont des adresses auxquelles ont été rangés deux symboles d'un même mot, alors $x_j$ - $x_i$ est inférieur à la longueur d'un mot n. Or $|x_j - x_i| = |z|$, donc $|z| < n$.

Réciproquement, si k vérifie kp = M$'$(Bn) + z et si $|z| < n$, alors il existe dans la séquence émise deux symboles d'un même mot à l'intervalle de k symboles.

L'intervalle minimal, $k_{min}$, est le plus petit de ces nombres k.

Pour un couple de paramètres n (longueur des mots codés) et B (nombre de mots rangés pour l'entrelacement) quelconque, il est possible de calculer pour chaque nombre p non diviseur de Bn la répartition des symboles dans la séquence entrelacée, et en particulier l'intervalle minimal $k_{min}$ séparant deux symboles issus d'un même mot codé. Par exemple, pour n = 12 et B = 13 avec :

. p = 23, $k_{min}$ = 7

. p = 25, $k_{min}$ = 6

. p = 97, $k_{min}$ = 8.

La répartition des intervalles entre symboles d'un même mot de code pour les 143 = 13×11 intervalles entre symboles successifs d'un même mot est la suivante : par exemple pour p = 23 : 85 intervalles dont la longueur est minimale $k_{min}$ = 7 ; 47 intervalles dont la longueur est k = 20 ; 11 intervalles dont la longueur est k = 27

Pour p = 25 : 75 intervalles dont la longueur est $k_{min}$ = 6 ; 7 intervalles dont la longueur est k = 19 ; 11 intervalles dont la longueur est k = 25.

Enfin pour p = 97 : 97 intervalles dont la longueur est $k_{min}$ = 8 ; 35 intervalles dont la longueur est k = 21 ;- 11 intervalles dont la longueur est k = 29.

Pour minimiser les risques de brouillage par des impulsions longues, pour une longueur n des mots codés, la taille de la matrice, c'est-à-dire le nombre B, puis le nombre p choisi pour générer la séquence, sont choisis pour que le maximum de symboles soient aussi éloignés que possible des autres symboles du même mot codé.

La séquence entrelacée n'est donc plus "pseudo-aléatoire" puisque les intervalles entre symboles d'un même mot, prennent un nombre limité de valeurs $B_i$. Par exemple, pour p = 23, $B_i \in \{7, 20, 27\}$, i = 1 à 3.

En contrepartie, une valeur minimale d'intervalle est garantie, et en conséquence une résistance minimale à des paquets d'erreurs. Cette valeur minimale est inférieure à l'intervalle de longueur B existant avec un entrelacement périodique dans lequel la matrice a la même taille.

Si la longueur minimale du paquet d'erreurs est imposée, la taille de la matrice devra être augmentée par rapport à celle qui serait utilisée pour cette longueur d'erreur dans un entrelacement périodique, ce qui augmente corrélativement le retard dans la transmission, fonction de la taille de la matrice comme indiqué ci-dessus.

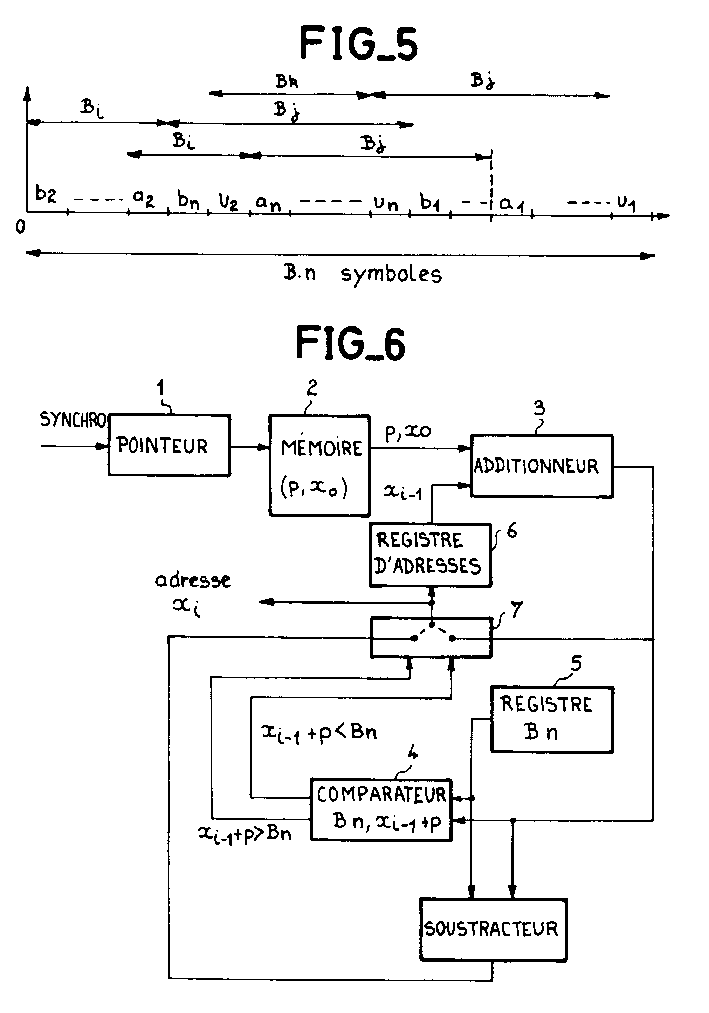

La figure 5 représente un exemple de séquence entrelacée obtenue par le procédé selon l'invention où $B_i$, $B_j$ et $B_k$ sont trois valeurs d'intervalles possibles entre symboles d'un même mot.

Comme indiqué ci-dessus, les valeurs d'intervalles $B_i$ sont en nombre limité quand tous les paramètres ont été fixés. Pour assurer une plus grande dispersion dans les valeurs d'intervalles entre symboles d'un même mot, il est possible de modifier la séquence d'entrelacement d'une matrice à la suivante ainsi, en reprenant les exemples indiqués ci-dessus, si les valeurs de p sont p = 23, p = 25 et p = 97 pour trois matrices successives, la répartition de l'ensemble des 3×143 intervalles entre symboles appartenant à un même mot est la suivante :

- 75 Intervalles de longueur 6
- 85 intervalles de longueur 7
- 97 intervalles de longueur 8
- 57 intervalles de longueur 19
- 47 intervalles de longueur 20
- 35 intervalles de longueur 21

4

- 11 intervalles de longueur 25
- 11 intervalles de longueur 27
- 11 intervalles de longueur 29,
  c'est-à-dire une répartition assez variée des longueurs.

Si le rang de départ $x_o$ varie d'une matrice à la suivante, avec un même pas p, les séquences générées pour l'entrelacement

$$x_k = x_o + kp \text{ (modulo Bn)}$$

se déduisent les unes des autres par permutation circulaire. Elles ont donc des propriétés de répartition très voisines. En conséquence $x_o$ point de départ dans la matrice peut être choisi quelconque.

Le procédé de transmission suivant l'invention est donc en pratique le suivant :

1. La matrice d'entrelacement est fixée au départ, par la longueur n des mots codés et le nombre B de mots entrelacés ;

2. N jeux de paramètres (p, $x_o$) sont rangés dans une mémoire, la séquence de ces N jeux de paramètres offrant une répartition variée des intervalles entre symboles d'un même mot, en fonction du temps.

3. A l'émission, après remplissage de la matrice avec les mots codés à émettre, un jeu de paramètres (p, $x_o$) parmi les N est choisi. A chaque instant $t_i$ d'émission d'un symbole, l'opération

$$x_i = x_{i-1} + p \text{ (modulo Bn)}$$

est effectuée sur les adresses de lecture de la matrice, et le symbole d'adresse $x_i$ est émis. Le calcul de $x_i$ nécessite une addition, un test par rapport à la valeur Bn et éventuellement une soustraction $x_i - Bn$ si le résultat du test est $x_i$ Bn. Lorsque la matrice est entièrement lue, l'opération 3 est reprise. Si N est choisi égal à une puissance de 2 moins 1 : N = $2^m - 1$, alors le jeu de paramètres (p, $x_o$) choisi pour la lecture de la matrice suivante est adressé automatiquement au moyen d'un pointeur qui peut être un registre à décalage rebouclé, le rythme de décalage étant égal à la période de lecture-écriture de la matrice.

4. A la réception, une matrice de remplissage de mêmes dimensions que celle utilisée à l'émission est prévue pour la mise en mémoire des symboles reçus. Ces symboles sont rangés aux mêmes adresses que celles auxquelles ils étaient rangés avant l'émission.

Pour cela, de la même manière qu'à l'émission, une mémoire de jeux de paramètres (p, $x_o$) est adressée par un pointeur (registre à décalage rebouclé par exemple), initialisé de la même manière qu'à la réception et avec le décalage temporel nécessaire à la transmission et à la mise en mémoire dans la matrice de réception.

Après remplissage, la matrice est lue ligne par ligne pour restituer les mots codés.

Ce procédé d'entrelacement n'introduit pas de retard supplémentaire par rapport à un procédé d'entrelacement périodique : le délai de transmission est 2Bn symboles.

La figure 6 représente un schéma synoptique des moyens de commande, en émission (ou en réception) pour l'entrelacement (ou le désentrelacement), pour le calcul des adresses $x_i$ de lecture en émission ou d'écriture en réception. Le rythme de travail est le rythme symbole. Un pointeur 1 est initialisé par un signal de synchronisation et travaille au rythme Bn symboles. Il adresse une mémoire 2 contenant N jeux de paramètres (p, $x_o$). Les paramètres lus dans cette mémoire changent donc, d'une matrice à la suivante. Ces paramètres d'initialisation pour la lecture (ou l'écriture) d'une matrice sont transmis à un additionneur 3 qui effectue au rythme symbole l'opération $x_{i-1} + p$, cet additionneur recevant également l'adresse $x_{i-1}$ précédente obtenue comme indiqué ci-dessous. Cet additionneur 3 est relié à une entrée d'un comparateur 4 dont l'autre entrée est reliée à un registre 5 fournissant la valeur B.n.

Si $x_{i-1} + p$ est inférieure à Bn, cette valeur constitue l'adresse suivante $x_i$. Pour cela la sortie de l'additionneur 3 est également reliée à l'entrée d'un registre d'adresses 6 par l'intermédiaire d'un commutateur 7.

Si $x_{i-1} + p$ est supérieure à B.n, alors un soustracteur 8, dont la première entrée est reliée à la sortie de l'additionneur 3 et la seconde entrée à la sortie du registre B.n, 5, effectue l'opération $(x_{i-1} + p) - Bn$ pour obtenir l'adresse $x_i$ qui est alors appliquée à l'entrée du registre d'adresses 6 via la seconde entrée du commutateur 7. La valeur d'adresses dans le registre 6 est alors utilisée pour la lecture ou l'écriture dans la matrice, et sert d'adresse $x_{i-1}$ pour le calcul d'adresse suivant.

Ce procédé de transmission est mis en oeuvre dans un dispositif de transmission comportant une mémoire RAM de données gérée par un premier microprocesseur pour l'entrelacement et/ou le désentrelacement des symboles des mots codés, type MP6809 de MOTOROLA par exemple, un autre microprocesseur identique étant utilisé pour le codage-décodage et associé à une mémoire de travail. La programmation de ces processeurs pour la mise en oeuvre du procédé selon l'invention est à la portée de l'homme de l'art.

L'invention n'est pas limitée au mode de réalisation précisément décrit et représenté. En particulier, dans un mode simplifié, il est possible d'utiliser toujours le même jeu de paramètres $(x_o, p)$.

Au contraire dans un mode plus élaboré, il est possible en outre de modifier la taille de la matrice.

## Revendications

1. Procédé de transmission d'informations codées par un code correcteur d'erreurs, résistant au brouillage, dans lequel les B.n symboles d'une séquence de B mots codés de n symboles, B et n nombres entiers, sont entrelacés après codage pour leur transmission, et réordonnés dans l'ordre initial résultant du codage pour le décodage après réception, caractérisé en ce que :
   - à l'émission, l'entrelacement est obtenu en émettant successivement les symboles de la séquence codée de rangs donnés par la suite $x_k = x_o + kp$ (modulo Bn), où $x_o$ est un rang de départ quelconque dans la séquence codée et p le pas de la suite, p étant un nombre entier premier, avec B.n, et k prenant les valeurs 0, 1 ... Bn-1,
   - à la réception, l'ordre initial résultant du codage est retrouvé en rangeant les symboles successifs de la séquence entrelacée correspondante reçue aux rangs calculés par la même suite $x_k = x_o + kp$ (modulo B.n),

      et en ce que le pas p de la suite est supérieur à n et choisi tel que l'intervalle minimum entre deux symboles (Rmin) d'un même mot dans la séquence entrelacée est supérieur ou égal à une valeur prédéfinie, ce pas étant déterminé à partir des paramètres de la séquence, nombre de mots B et nombre de symboles par mot et les intervalles entre symboles d'un même mot prenant un nombre limité de valeurs (Bi).

2. Procédé selon la revendication 1, caractérisé en ce que les séquences successives de B.n symboles sont entrelacées différemment d'une séquence à la suivante, les rangs d'émission des symboles de ces séquences étant générées par des lois de la même forme mais ayant des rangs de départ $x_o$ et des pas p différents, une suite de N couples de paramètres $(x_o, P)$ associée aux séquences successives étant prédéfinie et mise en mémoire dans l'émetteur et dans le récepteur.

3. Procédé selon la revendication 2, caractérisé en ce que la suite des couples de paramètres est choisie pour que la répartition des intervalles entre symboles d'un même mot dans la séquence entrelacée soit variée.

4. Dispositif de transmission d'informations destiné à la mise en oeuvre du procédé selon l'une quelconque des revendications 1 à 3, caractérisé en ce qu'il comporte des moyens de commande générant en émission les rangs des symboles dans la séquence codée pour former la séquence entrelacée à transmettre, et en réception les rangs des symboles reçus successivement pour l'établissement de la séquence à décoder, ces moyens de commande comportant une mémoire (2) des couples de paramètres $(x_o, p)$ associés aux séquences de B.n symboles successives, un registre d'adresses (6), un additionneur (3) relié aux sorties de la mémoire de couples $(x_o, p)$ et du registre d'adresses pour calculer pour chaque symbole $x_i = x_{i-1} + p$, $x_{i-1}$ étant le rang calculé pour le symbole précédent, un comparateur (4) pour comparer les valeurs $x_i$ issues du comparateur, la sortie du comparateur étant reliée à l'entrée du registre d'adresses quand $x_i < B.n$ et reliée à l'entrée d'un soustracteur (8) quand $x_i \geq B.n$, la sortie du soustracteur étant alors reliée à l'entrée du registre d'adresses dont la sortie fournit l'adresse courante.

5. Dispositif selon la revendication 4, caractérisé en ce que les moyens de commande sont constitués par un microprocesseur associé à une mémoire RAM dans laquelle, les données sont mises en mémoire.

## Claims

1. A method for the transmission of information encoded by an error correcting code, resistant to interference, in which $B \cdot n$ symbols of a sequence of B encoded words of n symbols, B and n being integral numbers, are interlaced after encoding for the transmission thereof, and re-arranged in the initial order resulting from the encoding for decoding after reception, characterized in that:
   - on transmission such interlacing is performed by successively transmitting the symbols of the encoded sequence of ranks defined by the series $x_k = x_o + k_p$ (modulo Bn), wherein $x_o$ is a random departure rank in the encoded sequence and p is the step of the series p being an integral prime number, with $B \cdot n$, and k assuming the values 0, 1...Bn-1,
   - on reception, the initial order resulting from the encoding is retrieved by arranging the successive symbols of the interlaced sequence corresponding to the ranks calculated by the same series $x_k = x_o + k_p$ (modulo $B \cdot n$),

      and in that the step p of the series is greater than n and selected in such a manner that the minimum number between two symbols (Rmin) of the same word of the interlaced series is greater than or equal to a predetermined value, said step being determined on the basis of parameters of the sequence, the number B of words and the number of symbols per word and the intervals between the symbols of a given word assuming a limited number of values (Bi).

2. The method as claimed in claim 1, characterized in that the successive sequences of $B \cdot n$ symbols are interlaced differently from one sequence to the next one, the ranks of transmission of the symbols of these sequences being generated by laws of the same form but having different initial ranks $x_o$ and steps p, one series of N pairs of parameters ($x_o$ and p) associated with the successive sequences being predetermined and stored in the memory of the transmitter and in the receiver.

3. The method as claimed in claim 2, characterized in that series of pairs of parameters is selected so that the distribution of the intervals between the symbols of the same word in the interlaced series is varied.

4. A device for the transmission of information for the implementation of the method as claimed in any one of the preceding claims 1 through 3, characterized in that it comprises control means generating, during transmission, the ranks of the symbols in the encoded sequence in order to constitute the interlaced sequence to be transmitted, and in that, during reception, the ranks of the symbols received successively for the establishment of the sequence to be decoded, said control means comprising a memory (2) for the pairs of parameter ($x_o$ and p) associated with the sequences of $B \cdot n$ successive symbol, an address register (6), an adder (3) connected with the output of the memory ($x_o$ and p) for the pairs and of the address register in order to calculate, for each symbol, $x_i = x_{i-1} + p$, $x_{i-1}$ being the rank calculated for the preceding symbol, a comparator (4) in order to compare the values xi coming from the comparator, the output of the comparators being connected with the input of the address register when $x_i < B \cdot n$ and being connected with the input of a subtracter (8) when $x_i \geq B \cdot n$, the output of the subtracter being then connected with the input of the address register, whose output supplies the current address.

5. The device as claimed in claim 4, characterized in that the control means are constituted by a microprocessor associated with a RAM in which the data are stored.

## Patentansprüche

1. Verfahren für die Übertragung von mittels eines Fehlerkorrekturkodes kodierten Informationen, das gegen Störungen resistent ist und in dem die $B \cdot n$ Zeichen einer Abfolge von B kodierten Wörtern aus je n Zeichen, B und n ganzzahlig, nach der Kodierung für ihre Übertragung verschachtelt werden und nach dem Empfang für die Dekodierung erneut in der aus der Kodierung sich ergebenden anfänglichen Reihenfolge geordnet werden, dadurch gekennzeichnet, daß:
   - beim Senden die Verschachtelung dadurch erzielt wird, daß nacheinander die Zeichen der kodierten Abfolge von durch die Folge $x_k = x_o + kp$ (Modulo $B \cdot n$) gegebenem Rang ausgesandt werden, wobei $x_o$ ein beliebiger Startrang in der kodierten Abfolge ist und p die Schrittweite der Folge ist, wobei p eine ganze Zahl ist, die nicht durch $B \cdot n$ teilbar ist, und k die Werte 0, 1,...,Bn-1 annimmt,

- beim Empfang die bei der Kodierung sich ergebende anfängliche Reihenfolge wiederhergestellt wird, indem die aufeinanderfolgenden Zeichen der entsprechenden verschachtelten Abfolge, die an dem durch dieselbe Folge $x_k = x_o + kp$ (Modolo $B^\bullet n$) berechneten Rang empfangen wird, angeordnet werden,

und daß die Schrittweite p der Folge größer als n ist und so gewählt wird, daß das minimale Intervall zwischen zwei Zeichen (Rmin) desselben Wortes in der verschachtelten Abfolge größer oder gleich einem vordefinierten Wert ist, wobei diese Schrittweite anhand von Parametern der Abfolge bestimmt wird, wobei die Anzahl der Wörter B und die Anzahl der Zeichen pro Wort und die Intervalle zwischen den Zeichen desselben Wortes eine begrenzte Anzahl von Werten (Bi) annehmen.

2. Verfahren gemäß Anspruch 1, dadurch gekennzeichnet, daß die aufeinanderfolgenden Abfolgen von $B^\bullet n$ Zeichen von einer Abfolge zur nächsten unterschiedlich verschachtelt werden, wobei die Senderänge der Zeichen dieser Abfolgen durch Gesetze der gleichen Form, jedoch mit verschiedenen Anfangsrängen $x_o$ und Schrittweiten p, erzeugt werden, wobei eine Folge von N Paaren von Parametern $(x_o, p)$, die den aufeinanderfolgenden Abfolgen zugehört, vordefiniert ist und im Sender und im Empfänger gespeichert wird.

3. Verfahren gemäß Anspruch 2, dadurch gekennzeichnet, daß die Folge von Parameterpaaren so gewählt wird, daß die Aufteilung der Intervalle zwischen den Zeichen desselben Wortes in der verschachtelten Abfolge verändert wird.

4. Informationsübertragungseinrichtung, die dazu vorgesehen ist, das Verfahren gemäß einem der Ansprüche 1 bis 3 auszuführen, dadurch gekennzeichnet, daß sie Steuermittel umfaßt, die beim Senden die Ränge der Zeichen in der kodierten Abfolge erzeugen, um die zu übertragende verschachtelte Abfolge zu bilden, und die beim Empfang die Ränge der nacheinander empfangenen Zeichen erzeugen, um die zu dekodierende Abfolge herzustellen, wobei diese Steuermittel versehen sind mit einem Speicher (2) für den Abfolgen von aufeinanderfolgenden $B^\bullet n$ Zeichen zugeordnete Parameterpaare $(x_o, p)$, einem Adressenregister (6), einem mit den Ausgängen des Speichers der Paare $(x_o, p)$ und des Adressenregisters verbundenen Addierer (3), der für jedes Zeichen $x_i = x_{i-1} + p$ berechnet, wobei $x_{i-1}$ der berechnete Rang für das vorhergehende Zeichen ist, und einem Komparator (4) zum Vergleichen der vom Addierer ausgegebenen Werte xi, wobei der Ausgang des Komparators mit dem Eingang des Adressenregisters verbunden ist, wenn $x_i < B^\bullet n$, und mit dem Eingang eines Subtrahierers (8) verbunden ist, wenn $x_i \geq B^\bullet n$, so daß folglich der Ausgang des Subtrahierers mit dem Eingang des Adressenregisters verbunden ist, dessen Ausgang die momentane Adresse liefert.

5. Einrichtung gemäß Anspruch 4, dadurch gekennzeichnet, daß die Steuermittel einen Mikroprozessor aufweisen, der mit einem RAM-Speicher verbunden ist, in dem die Daten gespeichert werden.

# FIG_1

# FIG_2

# FIG_3

# FIG_4

# FIG_5

$B.n$ symboles

# FIG_6